Europäisches Patentamt

**European Patent Office**

Office européen des brevets

(19)

(11) **EP 1 413 064 B1**

(12) **EUROPÄISCHE PATENTSCHRIFT**

(45) Veröffentlichungstag und Bekanntmachung des Hinweises auf die Patenterteilung:
**08.06.2005 Patentblatt 2005/23**

(51) Int Cl.⁷: **H04B 1/04**, H03G 3/30, H03M 1/10

(21) Anmeldenummer: 02753030.2

(22) Anmeldetag: **18.07.2002**

(86) Internationale Anmeldenummer:
**PCT/DE2002/002653**

(87) Internationale Veröffentlichungsnummer:
**WO 2003/017506 (27.02.2003 Gazette 2003/09)**

(54) **VORRICHTUNG UND VERFAHREN ZUR OFFSET-KALIBRIERUNG DES LEISTUNGSSTEUERSIGNALS VON FUNKGERÄTEN**

DEVICE AND METHOD FOR OFFSET CALIBRATION OF THE POWER CONTROL SIGNAL OF RADIO DEVICES

DISPOSITIF ET PROCEDE DESTINES AU CALIBRAGE DU DECALAGE DU SIGNAL DE COMMANDE DE PUISSANCE D'APPAREILS RADIO

(84) Benannte Vertragsstaaten:
**DE DK FI FR GB IT SE**

(30) Priorität: **30.07.2001 DE 10137234**

(43) Veröffentlichungstag der Anmeldung:
**28.04.2004 Patentblatt 2004/18**

(73) Patentinhaber: **Infineon Technologies AG**
**81669 München (DE)**

(72) Erfinder:
• **WENZEL, Dietmar**
**81549 München (DE)**

• **WÜRTH, Robert**
**81827 München (DE)**
• **SCHLEDZ, Ralf-Rainer**
**85406 Zolling (DE)**

(74) Vertreter: **Lange, Thomas, Dr. et al**
**Patentanwälte**
**Lambsdorff & Lange,**
**Dingolfinger Strasse 6**
**81673 München (DE)**

(56) Entgegenhaltungen:
US-A- 5 381 148          US-A- 5 959 497
US-A- 6 057 732

**Beschreibung**

Die Erfindung betrifft eine Vorrichtung zur Korrektur des Offsetfehlers eines offsetfehlerbehafteten Leistungssteuersignals, mit dem die Verstärkung des Leistungsverstärkers eines Funkgeräts, und insbesondere eines Mobilfunkgeräts, vorgegeben wird. Des weiteren betrifft die Erfindung ein Verfahren zur Korrektur des Offsetfehlers eines offsetfehlerbehafteten Leistungssteuersignals.

Bei den gängigen Mobilfunkstandards werden die Nutzdaten in Form von Datenbursts übertragen. Hierzu muss zunächst die Sendeleistung des Mobilfunkgeräts von Null auf die gewünschte Sendeleistung hochgefahren werden, und mit dieser Sendeleistung werden dann die Nutzdaten übertragen. Anschließend wird die Sendeleistung wieder auf Null heruntergefahren. Das Herauf- und Herunterfahren der Sendeleistung darf nicht abrupt erfolgen, da es dann zu Störungen der Nachbarkanäle kommen würde. Derartige Nachbarkanalstörungen können weitgehend vermieden werden, wenn die Sendeleistung über einen gewissen Zeitraum hinweg in Form einer Leistungsrampe herauf- und heruntergefahren wird.

Zur Realisierung derartiger Leistungsrampen wird von einem Leistungsrampen-Generator ein ansteigendes bzw. abfallendes Leistungssteuersignal erzeugt, das dem Leistungsverstärker des Mobilfunkgeräts zugeführt wird. Mit diesem meist als Analogsignal ausgeführten Leistungssteuersignal wird der Verstärkungsfaktor des Leistungsverstärkers festgelegt. Dieses analoge Leistungssteuersignal wird bei den Lösungen des Stands der Technik dadurch erzeugt, dass ein vom Leistungsrampen-Generator bereitgestellter digitaler Leistungsvorgabewert einer Digital-Analog-Wandlung unterworfen wird.

Dabei tritt als wesentliche Fehlergröße des so erhaltenen analogen Leistungssteuersignals eine Offsetverschiebung auf, die durch die im analogen Signalverarbeitungspfad befindlichen Digital-/Analog-Wandler und Operationsverstärker verursacht wird. Wegen dieser Offsetverschiebung weicht die Hochfrequenz-Sendeleistung vom gewünschten programmierten Wert ab, und es kann zu Transienten bei der abgestrahlten Sendeleistung kommen, die sich insbesondere bei kleinen Werten des Leistungssteuersignals bemerkbar machen. Infolge der Offset-Verschiebung des analogen Leistungssteuersignals beginnt die Aufwärtsrampe, welche zum Herauffahren der Sendeleistung dient, nicht exakt bei Null. Entsprechend wird durch die Offset-Verschiebung verhindert, dass die Sendeleistung mittels einer Abwärtsrampe bis auf Null heruntergefahren werden kann.

Die Offset-Verschiebung hat ihre Ursache in den im Leistungssteuerpfad auftretenden Toleranzen, denen analoge Schaltkreise grundsätzlich unterliegen und die durch Herstellungsprozesse, Alterung, Temperatur- und Druckschwankungen etc. hervorgerufen werden.

Toleranzen aufgrund von Herstellungsprozessen lassen sich im allgemeinen durch einen Abgleich mit einem bekannten Normal beseitigen. Hierzu wird bei einem werksseitigen Abgleich der Offset ermittelt und durch eine gerätespezifische Leistungsrampen-Programmierung ausgeglichen. Die durch Alterung, Temperatur- und Druckschwankungen hervorgerufenen Toleranzen auf den analogen Steuersignalen, und insbesondere auf dem Leistungssteuersignal, lassen sich mit einem werksseitigen Abgleich jedoch nicht in den Griff bekommen. Eine Korrektur während des Betriebs ist bei bisherigen Lösungen des Stands der Technik bestenfalls in der Weise möglich, dass aufgrund von empirisch ermittelten Zusammenhängen eine Schätzung des Offsets anhand von Temperaturmesswerten vorgenommen wird. Anschließend kann die Leistungsrampe entsprechend dieser Schätzung umprogrammiert werden. Beispiele solcher Lösungen des Stands der Technik sind in den Produkten PMB 6850 E-GOLD+ V1.2 implementiert.

Aus der Druckschrift US 5,959,497 ist eine Schaltung zur Leistungssteuerung für einen Leistungsverstärker in einem Mobilfunkgerät bekannt, welche einen digitalen Leistungsrampen-Generator umfasst. Ferner sind eine Messeinrichtung, welche zu verschiedenen Kalibrierwerten das zugehörige Leistungssteuersignal misst, sowie eine Steuereinheit, welche aus verschiedenen Kalibrierwerten und den zugehörigen Messwerten des Leistungssteuersignals den Offsetfehler des Leistungssteuersignals ermittelt, vorgesehen. Darüber hinaus umfasst die Schaltung zur Leistungssteuerung Mittel zur Korrektur der Leistungsrampen um den ermittelten Offsetfehler. Außerdem ist ein Leistungssteuerpfad in Form eines Digital-/Analog-Wandlers vorgesehen, welcher die vom Leistungsrampen-Generator erzeugten Digitalwerte in ein analoges Leistungssteuersignal umsetzt.

Nachteilig an der aus der Druckschrift US 5,959,497 bekannten Schaltung ist, dass der Digital-/Analog-Wandler positive wie auch negative ansteuernde Signale verarbeiten können muss, wodurch bei vorgegebener Wortbreite des Digital-/Analog-Wandlers die Empfindlichkeit gegenüber der Empfindlichkeit eines Digital-/Analog-Wandlers mit nur positiven Eingangssignalen reduziert wird.

Aufgabe der Erfindung ist es daher, eine Vorrichtung sowie ein Verfahren zur Korrektur des Offsetfehlers eines offsetfehlerbehafteten Leistungssteuersignals zur Verfügung zu stellen, welche bzw. welches bei einem Hardware-effizienten Aufbau eine hohe Genauigkeit zeigt.

Diese Aufgabe der Erfindung wird durch eine Vorrichtung zur Korrektur des Offsetfehlers eines offsetfehlerbehafteten Leistungssteuersignals gemäß Anspruch 1, durch eine Mobilfunkstation gemäß Anspruch 16 sowie durch ein Verfahren zur Korrektur des Offsetfehlers eines offsetfehlerbehafteten Leistungssteuersignals gemäß Anspruch 18 gelöst.

Die erfindungsgemäße Vorrichtung dient zur Korrektur des Offsetfehlers eines offsetfehlerbehafteten Leistungssteuersignals, mit dem die Verstärkung des Leistungsverstärkers eines Funkgeräts, und insbesondere eines Mobilfunkgeräts, vorgegeben wird. Die erfindungsgemäße Vorrichtung umfasst einen Leistungsrampen-Generator, mit dem zum einen Leistungsrampen zum Herauf- und Herunterfahren der Sendeleistung als Folge von Digitalwerten und zum anderen Kalibrierwerte als digitale Kalibrierwerte zur Ermittlung des Offsetfehlers erzeugbar sind. Außerdem umfasst die Vorrichtung eine Messeinrichtung, welche zu verschiedenen Kalibrierwerten das zugehörige Leistungssteuersignal misst. Eine Steuereinheit ermittelt aus den verschiedenen Kalibrierwerten und den zugehörigen Messwerten des Leistungssteuersignals den Offsetfehler des Leistungssteuersignals. Des weiteren umfasst die Vorrichtung Mittel zur Korrektur der vom Leistungsrampen-Generator erzeugbaren Leistungsrampen um den ermittelten Offsetfehler. Darüber hinaus beinhaltet die Vorrichtung einen Leistungssteuerpfad, der erstens einen Digital-/Analog-Wandler umfasst, welcher die vom Leistungsrampen-Generator erzeugten Digitalwerte in das analoge Leistungssteuersignal, das den Sollwert der Sendeleistung vorgibt, umsetzt und zweitens einen analogen Subtrahierer, mit dem das verstärkte oder unverstärkte analoge Ergebnissignal des Digital-/Analog-Wandlers um eine vorgegebene Vorspannung vermindert werden kann.

Erfindungsgemäß wird der Leistungsrampen-Generator zur Erzeugung von Kalibrierwerten eingesetzt, die durch den Leistungssteuerpfad in ein zugehöriges Leistungssteuersignal umgesetzt werden. Die zu den verschiedenen Kalibrierwerten gehörigen Werte des Leistungssteuersignals werden gemessen und die Steuereinheit ermittelt dann aus diesen Wertepaaren den Offsetfehler, um den die vom Leistungsrampen-Generator erzeugbaren Leistungsrampen dann korrigiert werden.

Da der Leistungsrampen-Generator erfindungsgemäß als digitale Signalverarbeitungsstufe ausgeführt wird, lassen sich auch komplexere Leistungsrampenverläufe realisieren. Hierzu wird der gewünschte Leistungsrampenverlauf als Folge von Digitalwerten abgespeichert und nach Bedarf ausgegeben. Der Leistungsrampen-Generator kann auch die benötigten Kalibrierwerte als digitale Kalibrierwerte liefern. Mit Hilfe der Digitaltechnik lassen sich komplexe Abläufe von Leistungsrampen und Kalibrierwerten auf einfache und flexible Weise programmieren.

Der durch Toleranzen im Leistungssteuerpfad, und insbesondere durch Toleranzen des Digital-/Analog-Wandlers (sowie eventuell des nachgeschalteten Verstärkers) verursachte Offset des Leistungssteuersignals kann sowohl positive als auch negative Werte annehmen. Ein negativer Offsetfehler kann auf einfache Weise kompensiert werden, indem ein positiver Offsetfehler-Korrekturwert zu dem vom Leistungsrampen-Generator erzeugten Leistungsvorgabesignal addiert wird. Im Falle eines positiven Offsetfehlers müsste dagegen ein negativer Offsetfehler-Korrekturwert zu dem Leistungsvorgabesignal addiert werden. Um den Wertebereich der Ergebnissignale auf positive Werte zu beschränken und nur positive Ausgangsspannungen beim Digital/Analog-Wandler zuzulassen, ist erfindungsgemäß ein analoger Subtrahierer vorgesehen, mit dem man im Falle eines positiven Offsetfehlers das analoge, ausschließlich positive Ergebnissignal des Digital-/Analog-Wandlers um eine vorgegebene Vorspannung $U_V$ vermindern kann. Durch Subtraktion der Vorspannung $U_V$ kann ein positiver Offsetfehler in einen negativen offsetfehler umgewandelt werden, welcher dann wieder durch Addieren eines positiven Offsetfehler-Korrekturwerts kompensierbar ist. Mittels des analogen Subtrahierers kann daher erreicht werden, dass der Offsetfehler stets durch Addition eines positiven Offsetfehler-Korrekturwerts beseitigt werden kann und stets nur positive Ergebnissignale des Digital/Analog-Wandlers erforderlich sind.

Mit der erfindungsgemäßen Vorrichtung ist eine Selbstkalibrierung zur Kompensation des Offsetfehlers während des laufenden Betriebs möglich. Hierzu werden keine externen Messvorrichtungen oder Eichnormale benötigt, die Kalibrierung kann vollständig durch das Mobilfunkgerät selbst vorgenommen werden.

Zur Durchführung der Kalibrierung eignen sich Sendepausen zwischen verschiedenen Übertragungsbursts. Alternativ dazu kann die Kalibrierung im Bereitschaftszustand des Handys durchgeführt werden. Da die Ermittlung des Offsetfehlers sowie die Korrektur desselben innerhalb kurzer Zeit durchführbar sind, reichen kurze Sendepausen zur Durchführung der Selbstkalibrierung aus.

Die vom Leistungsrampen-Generator erzeugbaren Leistungsrampen werden um den ermittelten Offsetfehler korrigiert. Im Leistungsrampen-Generator muss lediglich eine einzige Aufwärts- bzw. Abwärtsrampe abgespeichert sein, welche dann an den ermittelten Offsetfehler angepasst wird. Es ist daher nicht notwendig, dass im Leistungsrampen-Generator für eine spezielle Rampenform jeweils verschiedene Aufwärts- bzw. Abwärtsrampen für verschiedene Offsetfehlerbereiche abgespeichert sind. Da offset-spezifische Leistungsrampen nicht erforderlich sind, wird im Leistungsrampen-Generator nur der Speicherplatz für eine Aufwärts- bzw. Abwärtsrampe für eine spezielle Rampenform benötigt.

Unabhängig von den Umgebungsbedingungen, von Temperatur- und Druckschwankungen kann mittels der erfindungsgemäßen Vorrichtung ein offsetunabhängiger Zusammenhang zwischen der jeweiligen, vom Leistungsrampen-Generator erzeugten Leistungsvorgabe und dem eigentlichen Leistungssteuersignal gewährleistet werden. Die Eliminierung des Offsetfehlers stellt sicher, dass der Leistungssteuerpfad im linearen Bereich arbeitet und dass die vom Leistungsrampen-Generator erzeugte Leistungsvorgabe, beispielsweise die vom Leistungsrampen-Generator erzeugte Aufwärts- bzw. Abwärtsrampe, linear in ein entsprechendes Leistungssteuersignal umgesetzt wird.

Durch die Kompensation des Offsetfehlers werden abrupte Übergänge vom nichtlinearen in den linearen Arbeitsbereich und umgekehrt beim Herauf- und Herunterfahren der Sendeleistung vermieden. Dadurch wird verhindert, dass transiente Vorgänge bzw. Überschwinger zu einer unerwünschten Abstrahlung von Leistung führen. Mit Hilfe der erfindungsgemäßen Lösung kann die Abstrahlung von Störsignalen, die zu einer Beeinträchtigung des Übertragungsverhaltens auf den Nachbarkanälen führt, stark verringert werden.

Der Leistungssteuerpfad, der die vom Leistungsrampen-Generator erzeugte Leistungsvorgabe in das Leistungssteuersignal umsetzt, soll insbesondere bis an die untere Grenze des linearen Bereichs betrieben werden können. Dadurch können auch geringe Ausgangsspannungen eingestellt werden, und der Dynamikbereich wird vergrößert.

Mit Hilfe der erfindungsgemäßen Lösung können insbesondere auch Leistungsverstärker unterstützt werden, die eine geringe Schwellspannung von beispielsweise 30 mV aufweisen und somit schon bei geringen Steuerspannungen Hochfrequenzleistung abgeben. Damit das Leistungssteuersignal den Leistungsverstärker zuverlässig auf Null herunterfahren kann, ist es gerade in diesen Fällen wichtig, entsprechend niedrige, offsetfehlerfreie Leistungssteuersignale, beispielsweise nicht größer als die Schwellspannung, erzeugen zu können. Dies wird durch die erfindungsgemäße Lösung möglich.

Es ist von Vorteil, wenn der Leistungsverstärker eine analoge Regelung umfasst, welche die Verstärkung des Leistungsverstärkers dem durch das Leistungssteuersignal vorgegebenen Sollwert nachführt.

Eine derartige, in Form eines Regelkreises ausgebildete analoge Regelung erfasst etwa über einen Sensor die tatsächliche Sendeleistung und regelt die Verstärkung des Leistungsverstärkers so nach, dass der Istwert der Sendeleistung dem durch das Leistungssteuersignal vorgegebenen Sollwert entspricht. Dadurch ist gewährleistet, dass die Verstärkung des Leistungsverstärkers ständig dem durch das Leistungssteuersignal vorgegebenen Sollwert nachgeführt wird.

Es ist von Vorteil, wenn zur Ermittlung des Offsetfehlers mindestens zwei verschiedene Kalibrierwerte sowie die zugehörigen Messwerte des Leistungssteuersignals herangezogen werden. Dabei ist es insbesondere von Vorteil, wenn die Steuereinheit den Offsetfehler durch eine lineare Näherung des Zusammenhangs zwischen den Kalibrierwerten und den zugehörigen Messwerten des Leistungssteuersignals bestimmt. Um den bei der Umsetzung der Kalibrierwerte in das zugehörige Leistungssteuersignal auftretenden Nullversatz bzw. Offset des Leistungssteuersignals bestimmen zu können, müssen mindestens zwei Wertepaare von Kalibrierwert und zugehörigem Leistungssteuersignal erfasst werden. Dabei kann davon ausgegangen werden, dass zwischen den Kalibrierwerten und den zugehörigen Leistungssteuersignalen ein weitgehend linearer Zusammenhang besteht. Durch die Steuereinheit kann dadurch eine geeignete Geradengleichung aufgestellt werden, deren Nullversatz den gewünschten Offsetfehler darstellt.

Gemäß einer weiteren vorteilhaften Ausführungsform der Erfindung umfasst der Leistungssteuerpfad einen dem Digital-/Analog-Wandler nachgeschalteten analogen Verstärker. Mit Hilfe dieses Verstärkers kann das Ausgabesignal des Digital-/Analog-Wandlers auf den für das Leistungssteuersignal erforderlichen Signalpegel verstärkt werden. Diese Signalverstärkung kann bereits auf dem Basisbandbaustein des Mobilfunkgeräts vorgenommen werden.

Es ist von Vorteil, wenn mittels der Steuereinheit festgelegt werden kann, ob die Vorspannung subtrahiert wird oder nicht. Die Steuereinheit ermittelt aus den Kalibrierwerten und den zugehörigen Leistungssteuersignalen den Offsetfehler. Wenn sich ein positiver Offsetfehler ergibt, dann veranlasst die Steuereinheit die Subtraktion um die Vorspannung $U_V$ und führt eine zweite Messung durch, bei der die zu verschiedenen Kalibrierwerten gehörigen Werte des Leistungssteuersignals gemessen werden.

Es ist von Vorteil, wenn die Mittel zur Korrektur des Offsetfehlers einen Addierer umfassen, der einen Offsetfehler-Korrekturwert zu den vom Leistungsrampen-Generator erzeugten Leistungsrampenwerten addiert. Die Kennlinie, welche die Abhängigkeit zwischen den vom Leistungsrampen-Generator erzeugten Leistungsrampenwerten und den daraus erzeugten Leistungsrampenwerten und den daraus erzeugten Leistungssteuersignalen darstellt, wird durch Addition des Offsetfehler-Korrekturwerts so verschoben, dass der Ordinatenachsenabschnitt des Geraden-Anteils Null ist. Die Addition des Offsetfehler-Korrekturwerts beseitigt also den Nullversatz des Geraden-Anteils dieser Kennlinie. Dadurch wird erreicht, dass im Fall einer Aufwärtsrampe die Sendeleistung von Null ausgehend auf den gewünschten Wert hochgefahren werden kann. Umgekehrt kann im Fall einer Abwärtsrampe sichergestellt werden, dass die Leistung auch wirklich bis auf Null heruntergefahren werden kann. Bei dem Addierer, der den Offsetfehler-Korrekturwert zu den Leistungsrampenwerten addiert, handelt es sich vorzugsweise um einen digitalen Addierer, der dem Leistungsrampen-Generator nachgeschaltet ist.

Alternativ dazu ist es von Vorteil, wenn die Mittel zur Korrektur des Offsetfehlers die abgespeicherte Folge von Leistungsrampenwerten durch Addition eines Offsetfehler-Korrekturwerts so modifizieren, dass der ermittelte Offsetfehler kompensiert ist. Anstatt den Offsetfehler-Korrekturwert mittels eines dem Leistungsrampen-Generator nachgeschalteten Addierers während der Ausgabe der Leistungsrampenwerte zu korrigieren, wird bei dieser Lösung die abgespeicherte Leistungsrampe im Speicher modifiziert, indem der Offsetfehler-Korrekturwert zu sämtlichen Leistungsrampenwerten addiert wird. Die abgespeicherte Leistungsrampe wird also vor dem Ausgeben im Speicher korrigiert. Dadurch stehen beim Ausgeben der Leistungsrampe dann sofort die korrigierten Leistungsrampenwerte zur Verfügung, so dass Verzögerungen im Leistungssteuerpfad vermieden werden.

Es ist von Vorteil, wenn in der Messeinrichtung die Potentialdifferenz zwischen dem Leistungssteuersignal und einem festen Referenzpotential, insbesondere dem Massepotential, ermittelt wird. In der Messeinrichtung muss das Leistungssteuersignal zu verschiedenen Zeitpunkten zuverlässig erfasst werden. Dazu wird das Leistungssteuersignal auf ein festes Referenzpotential bezogen, wobei dieses Referenzpotential nur geringfügige Schwankungen aufweisen darf. Deshalb eignet sich insbesondere das Massepotential als Referenzpotential für das Leistungssteuersignal.

Gemäß einer weiteren vorteilhaften Ausführungsform der Erfindung umfasst die Messeinrichtung einen steuerbaren Kreuzschalter, wobei mittels des steuerbaren Kreuzschalters eine Vorzeichenumkehr der zu verstärkenden Potentialdifferenz bewirkt werden kann. Aufgabe der erfindungsgemäßen Vorrichtung ist es, den im Leistungssteuerpfad auftretenden Offset zu beseitigen. Hierzu muss das Leistungssteuersignal von der Messeinrichtung zu verschiedenen Zeitpunkten möglichst genau erfasst werden. Allerdings weist auch der Messpfad infolge von Bauteiltoleranzen einen Messpfad-Offset auf, der die Messergebnisse verfälscht. Dadurch wird der Erfolg der Kalibrierung fraglich. Mit Hilfe des steuerbaren Kreuzschalters lassen sich die beiden Signalleitungen, an denen die zu verstärkende Potentialdifferenz anliegt, vertauschen. Hierzu wird der steuerbare Kreuzschalter durch die Steuereinheit so gesteuert, dass für jeden zu erfassenden Wert des Leistungssteuersignals bei der ersten Stellung des Kreuzschalters eine erste Messung und bei der zweiten Stellung des Kreuzschalters eine zweite Messung durchgeführt wird. Indem für jeden zu erfassenden Wert des Leistungssteuersignals zwei Messungen mit jeweils entgegengesetztem Vorzeichen der zu verstärkenden Potentialdifferenz vorgenommen werden, lässt sich der Messpfad-Offset bestimmen und rechnerisch beseitigen.

Es ist von Vorteil, wenn die Messeinrichtung einen Differenzverstärker zur Verstärkung der Potentialdifferenz umfasst. Außerdem ist es von Vorteil, wenn die Messeinrichtung einen Analog-/Digital-Wandler zur Digitalisierung der Potentialdifferenz umfasst. Mit Hilfe des Differenzverstärkers kann der Signalpegel der Potentialdifferenz an die Eingangsempfindlichkeit des Analog-/Digital-Wandlers angeglichen werden. Der nachfolgende Analog-/Digital-Wandler des Messpfades wandelt das analoge Leistungssteuersignal in ein Digitalsignal um, das dann durch die Steuereinheit ausgewertet werden kann. Anhand des digitalisierten Leistungssteuersignals kann die Steuereinheit den Offsetfehler ermitteln.

Gemäß einer weiteren vorteilhaften Ausführungsform der Erfindung umfasst die Vorrichtung ein Schaltelement für den Leistungsverstärker, mit dem der Leistungsverstärker während des Kalibriervorgangs ausschaltbar ist. Während des Kalibriervorgangs werden die verschiedenen vom Leistungsrampen-Generator vorgegebenen Kalibrierwerte in entsprechende Leistungssteuersignale umgesetzt, welche auch am Leistungsverstärker anliegen. Wenn der Leistungsverstärker während des Kalibriervorgangs eingeschaltet wäre, so käme es zu einer unerwünschten Abstrahlung von Leistung, welche zu einer erheblichen Störung des verwendeten Übertragungskanals führen würde. Daher muss der Leistungsverstärker während des Kalibriervorgangs inaktiv geschaltet werden, und dies geschieht mit Hilfe eines Schaltelements, welches über eine Steuerleitung von der Steuereinheit kontrolliert wird. Andernfalls ist es erforderlich, dass die Schwellspannung des Leistungsverstärkers höher ist als der verwendete Kalibrierwert.

Es ist von Vorteil, wenn der Leistungsrampen-Generator, die Messeinrichtung und die Steuereinheit oder eine entsprechende Teilkombination dieser Komponenten auf dem Basisbandbaustein bzw. den Basisbandbausteinen angeordnet sind. Die Integration sämtlicher für die Erzeugung der Leistungsrampen sowie für die Offsetfehlerkorrektur benötigten Baugruppen auf dem Basisbandbaustein ermöglicht eine platzsparende und kompakte Realisierung. Dadurch ist es möglich, Mobilfunkgeräte weiter zu verkleinern und gleichzeitig ihre Leistungsfähigkeit zu verbessern. Die Integration von digitalen und analogen Baugruppen auf ein und demselben integrierten Schaltkreis lässt sich mit Hilfe der Switched Capacitor- bzw. der Switched Operational Amplifier-Technologie ohne Probleme realisieren.

Es ist von Vorteil, wenn das vom Leistungssteuerpfad gelieferte Leistungssteuersignal der Messeinrichtung innerhalb eines Basisbandbausteins direkt zugeführt wird. Dies bedeutet, dass das Leistungssteuersignal der Messeinrichtung zugeführt wird, ohne den Basisbandbaustein zu verlassen. Daher wird am Basisbandbaustein kein zusätzlicher Anschluss für ein Messsignal benötigt. Die erfindungsgemäße Lösung zur Eliminierung des Offsets auf dem Leistungssteuersignal kann daher realisiert werden, ohne dass hierzu zusätzliche Signalpins belegt werden müssten.

Es ist von Vorteil, wenn die Vorrichtung zur Korrektur des Offsetfehlers in einer Mobilfunkstation eingesetzt wird, und wenn die Datenübertragung entsprechend einem der Standards GSM, EDGE, TIA-/EIA-136, UMTS oder entsprechend von Teilkombinationen dieser Standards erfolgt. Bei den meisten genannten Standards werden die Nutzdaten in Form von Datenbursts übertragen. Der Einsatz der erfindungsgemäßen Offsetkalibrierung ist hier von Vorteil, damit die Sendeleistung vor Beginn der Übertragung exakt von Null aus hochgefahren und nach Beendigung der Übertragung wieder exakt auf Null heruntergefahren werden kann. Abrupte Einschalt- und Ausschaltvorgänge können so vermieden werden.

Das erfindungsgemäße Verfahren betrifft die Korrektur des Offsetfehlers eines offsetfehlerbehafteten Leistungssteuersignals, mit dem die Verstärkung des Leistungsverstärkers eines Funkgeräts, und insbesondere eines Mobilfunkgeräts, vorgegeben wird. In einem ersten Schritt werden mittels des Leistungsrampen-Generators, mit dem auch die Leistungsrampen zum Herauf- und Herunterfahren der Sendeleistung erzeugbar sind, verschiedene Kalibrierwerte zur Ermittlung des Offsetfehlers erzeugt. Die zu den verschiedenen Kalibrierwerten gehörigen Werte des Leistungssteuersignals werden gemessen und anschließend wird aus den verschiedenen Kalibrierwerten sowie den zugehörigen Messwerten des Leistungssteuersignals der Offsetfehler ermittelt. In dem sich anschließenden Schritt werden die vom Leistungsrampen-Generator erzeugbaren Leistungsrampen um den ermittelten Offsetfehler korrigiert.

Mit Hilfe des erfindungsgemäßen Verfahrens kann der störende Offset auf dem Leistungssteuersignal durch eine Selbstkalibrierung beseitigt werden. Das erfindungsgemäße Verfahren erfordert keine externen Hilfsmittel und kann während des laufenden Betriebs des Funkgeräts innerhalb kurzer Zeit durchgeführt werden.

Nachfolgend wird die Erfindung anhand eines in der Zeichnung dargestellten Ausführungsbeispiels weiter beschrieben. Es zeigen:

Fig. 1     ein Blockschaltbild der erfindungsgemäßen Vorrichtung zur Offset-Kalibrierung;

Fig. 2     den Zusammenhang zwischen dem digitalen Leistungsvorgabesignal D des Leistungsrampen-Generators und dem analogen Leistungssteuersignal $U_P$;

Fig. 3     den zeitlichen Verlauf des Leistungssteuersignals Up während der Offset-Kalibrierung; sowie

Fig. 4     den zeitlichen Verlauf des Leistungssteuersignals $U_P$ für einen beispielhaft dargestellten Datenburst, wenn zuvor eine Offset-Kalibrierung stattgefunden hat.

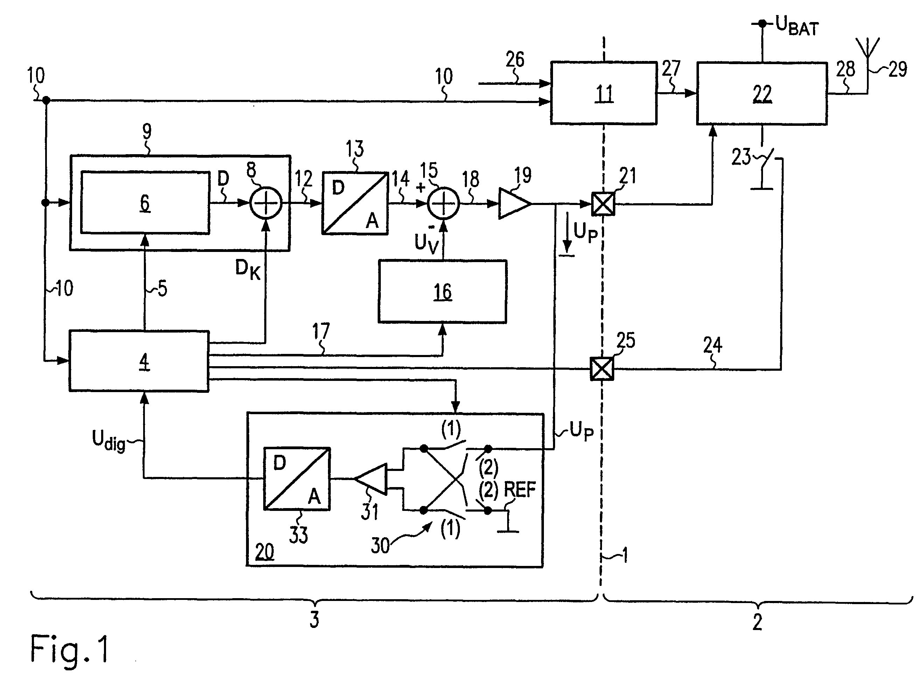

In Fig. 1 ist die Anordnung zur Offset-Kalibrierung des Leistungssteuersignals in Form eines Blockschaltbilds aufgetragen. Die auf der rechten Seite der Bausteingrenze 1 befindlichen Baugruppen sind auf dem Hochfrequenzbaustein 2 untergebracht, während die links von der Bausteingrenze 1 befindlichen Baugruppen auf dem Basisbandbaustein 3 angeordnet sind.

Bevor die eigentlichen Nutzdaten in Form eines Datenbursts übertragen werden können, muss die Sendeleistung mittels einer Einschaltrampe von Null auf den gewünschten Sendeleistungswert hochgefahren werden. Hierzu übermittelt das Steuergerät 4 die Daten 5 für die Leistungsrampen an den Leistungsrampen-Generator 6. Daraufhin beginnt der Leistungsrampen-Generator 6, die Leistungsrampe als Folge digitaler Werte auszugeben. Dieses digitale Leistungsvorgabesignal D gelangt zum digitalen Addierer 8, welcher den digitalen Offsetkorrekturwert $D_K$ zu dem digitalen Leistungsvorgabesignal D addiert. Der Leistungsrampen-Generator 6 und der Addierer 8 bilden zusammen die Leistungsrampen-Steuerung 9. Zur Synchronisation der Leistungsrampen mit der Nutzdatenübertragung wird die Synchronisationsinformation 10 der Steuereinheit 4, der Leistungsrampen-Steuerung 9 sowie dem Modulator 11 zugeführt.

Der Offset-Korrekturwert $D_K$ wird durch die Steuereinheit 4 zur Verfügung gestellt und dient zur Kompensation des Offsetfehlers, welcher im weiteren Leistungssteuerpfad als Folge von Bauteiltoleranzen auftritt. Am Ausgang des Addierers 8 kann das offsetkorrigierte digitale Signal 12 abgegriffen werden, das dem Digital-/Analog-Wandler 13 zugeführt und in das analoge Leistungsvorgabesignal 14 umgewandelt wird.

Mit dem analogen Subtrahierer 15 kann bei Bedarf die Vorspannung $U_V$ von dem analogen Leistungsvorgabesignal 14 subtrahiert werden. Diese Vorspannung $U_V$ wird durch den Vorspannungs-Generator 16 zur Verfügung gestellt, der über das Steuersignal 17 von der Steuereinheit 4 kontrolliert wird. Über dieses Steuersignal 17 kann die Steuereinheit 4 festlegen, ob die Vorspannung $U_V$ von dem analogen Leistungsvorgabesignal 14 subtrahiert werden soll oder nicht. Das Ausgabesignal 18 des Subtrahierers wird dem Operationsverstärker 19 zugeführt, an dessen Ausgang das Leistungssteuersignal Up abgegriffen werden kann.

Das Leistungssteuersignal $U_P$ wird zum einen der Messeinrichtung 20 zugeführt. Außerdem gelangt das Leistungssteuersignal Up über den Signalpin 21 zum Leistungsverstärker 22, der sich auf dem Hochfrequenzbaustein 2 befindet. Der Leistungsverstärker 22 umfasst eine in Form eines Regelkreises ausgeführte analoge Regelung, welche die Verstärkung des Leistungsverstärkers regelt. Mittels dieses Regelkreises wird die Verstärkung des Leistungsverstärkers dem Leistungssteuersignal $U_P$ nachgeführt, wobei durch das Leistungssteuersignal Up der Sollwert der Sendeleistung vorgegeben wird. Mittels des Schaltelements 23 kann der Leistungsverstärker 22 inaktiv geschaltet werden. Das Schaltelement 23 für den Leistungsverstärker wird dabei über das Schaltsignal 24 von der Steuereinheit 4 kontrolliert, wobei das Schaltsignal 24 über den Signalpin 25 vom Basisbandbaustein 3 zum Hochfrequenzbaustein 2 geführt wird.

Nachdem die Sendeleistung mittels der Einschaltrampe auf den gewünschten Wert hochgefahren ist, kann mit der eigentlichen Nutzdatenübertragung begonnen werden. Hierzu formt der Modulator 11 aus den Daten 26 das modulierte Signal 27, welches vom Leistungsverstärker 22 verstärkt wird. Dabei wird der Leistungsverstärker 22 über die Versorgungsspannung $U_{BAT}$ mit Spannung versorgt. Der Leistungsverstärker 22 erzeugt das Sendesignal 28, das über die Antenne 29 abgestrahlt wird. Um die Nutzdatenübertragung mit dem Herauf- und Herunterfahren der Sendeleistung zu synchronisieren, wird auch dem Modulator 11 die Synchronisationsinformation 10 zugeführt.

Mit der Messeinrichtung 20 kann das Leistungssteuersignal Up gemessen werden. Hierzu wird das Leistungssteuersignal Up auf ein festes Referenzpotential REF bezogen. Als Referenzpotential REF eignet sich insbesondere das Massepotential. Mit Hilfe des steuerbaren Kreuzschalters 30 lassen sich die beiden Eingänge des hochohmigen Differenzverstärkers 31 vertauschen, um so den im Messpfad auftretenden Messpfad-Offset berechnen und beseitigen zu können. Für jeden zu erfassenden Messwert werden dabei hintereinander zwei Messungen durchgeführt. Bei der ersten der beiden Messungen sind die mit 1 bezeichneten Schalter des Kreuzschalters 30 geschlossen, während die mit 2 bezeichneten Schalter geöffnet sind. Dagegen sind bei der zweiten Messung die mit 2 bezeichneten Schalter geschlossen und die mit 1 bezeichneten Schalter geöffnet. Der steuerbare Kreuzschalter 30 wird über das Steuersignal 32 von der Steuereinheit 4 kontrolliert.

Das am Ausgang des Differenzverstärkers 31 anliegende verstärkte Analogsignal wird dem Analog-/Digital-Wandler 33 zugeführt, an dessen Ausgang der digitale Messwert $U_{dig}$ abgegriffen werden kann. Der Zusammenhang zwischen dem am Eingang der Messeinrichtung 20 anliegenden Leistungssteuersignal $U_P$ und dem digitalen Messwert $U_{dig}$ ist dabei durch die Gleichung

$$U_{dig} = g_{ADC} \cdot g_S \cdot U_P + U_{dig,0} \tag{1}$$

gegeben. Hierbei bezeichnet $g_S$ die Verstärkung des Differenzverstärkers 31, während $g_{ADC}$ die Verstärkung des Analog-/Digital-Wandlers 33 bezeichnet. Mit $U_{dig,0}$ wird der Digitalwert bezeichnet, welcher der Potentialdifferenz 0V zugeordnet wird. Hieraus ergibt sich die Spannung $U_P$ des Leistungssteuersignals zu

$$U_P = \frac{U_{dig} - U_{dig,0}}{g_{ADC} \cdot g_S}. \tag{2}$$

Wird das Leistungssteuersignal Up einmal mit der Schalterstellung (1) und einmal mit der Schalterstellung (2) des Kreuzschalters 30 gemessen, so kann ein eventuell vorhandener Messpfad-Offset in der Messeinrichtung 20, welcher durch den Differenzverstärker 31 und den Analog-/Digital-Wandler 33 verursacht wird, durch folgende Berechnung eliminiert werden:

$$U'_{dig} = \frac{1}{2} \cdot \left( U_{dig}^{(1)} - U_{dig}^{(2)} \right) + U_{dig,0,ideal} \tag{3}$$

$U_{dig,0,ideal}$ ist dabei der digitale Wert, der im Idealfall der Potentialdifferenz 0V zugeordnet wird. Falls der Messpfad-Offset auf diese Weise eliminiert wird, so muss in der oben angeführten Gleichung (2) der Digitalwert $U_{dig,0}$ durch den Idealwert $U_{dig,0,ideal}$ ersetzt werden, so dass sich ergibt:

$$U_P = \frac{U'_{dig} - U_{dig,0,ideal}}{g_{ADC} \cdot g_S} \tag{4}$$

Im folgenden soll beschrieben werden, auf welche Weise eine Kalibrierung zur Ermittlung des im Leistungssteuerpfads auftretenden Offsetfehlers auf dem Leistungssteuersignal durchgeführt werden kann. Der Kalibriervorgang kann während des Betriebs, insbesondere in Sendepausen zwischen der Übertragung verschiedener Datenbursts oder im Bereitschaftszustand des Mobilfunkgeräts durchgeführt werden.

Zur Bestimmung des Offsets des Leistungssteuersignals Up sind mindestens zwei Messungen mit unterschiedlichen Spannungen $U_{P1}$ und $U_{P2}$ erforderlich. Um nacheinander die beiden Spannungen $U_{P1}$ und $U_{P2}$ am Ausgang des Leistungssteuerpfads abgreifen zu können, speist der Leistungsrampen-Generator 6 nacheinander als digitales Leistungsvorgabesignal zwei digitale Werte $D_1$ und $D_2$ in den Leistungssteuerpfad ein. Während des Kalibriervorgangs ist der Offset-Korrekturwert $D_K$, der von der Steuereinheit 4 vorgegeben wird, zunächst auf Null gesetzt. Durch den digitalen Addierer 8 werden daher die digitalen Werte $D_1$ und $D_2$ nicht verändert. Auch die vom Vorspannungs-Generator 16 erzeugbare Vorspannung $U_V$, die mittels des Steuersignals 17 von der Steuereinheit 4 kontrolliert wird, ist zunächst ausgeschaltet.

Am Ausgang des Leistungssteuerpfads können nacheinander die Werte $U_{P1}$ und $U_{P2}$ des Leistungssteuersignals abgegriffen und mittels der Messeinrichtung 20 ausgewertet werden. Bei Annahme eines linearen Zusammenhangs zwischen dem digitalen Leistungsvorgabesignal D und dem Leistungssteuersignal Up ergibt sich der Offsetfehler $U_{off}$ dann zu

$$U_{off} = U_{P1} - \frac{U_{P2} - U_{P1}}{D_2 - D_1} \cdot D_1 \tag{5}$$

Die beiden Messpunkte ($D_1$; $U_{P1}$) sowie ($D_2$; $U_{P2}$) sollten derart gewählt werden, dass eine möglichst hohe Genauigkeit bei der Bestimmung des Offset-Fehlers $U_{off}$ erzielt wird. Dabei treten unterschiedliche Effekte auf. Der Quantisierungsfehler des Analog-/Digital-Wandlers 33 ist bei kleinen Spannungen $U_P$ dominierend, während bei großen Spannungen Up die Verstärkungsfehler des Differenzverstärkers 31 sowie des Analog-/DigitalWandlers 33 maßgeblich sind. Der Leistungsverstärker 22 ist während des Kalibriervorgangs deaktiviert, um zu verhindern, dass Leistung abgestrahlt wird. Hierzu schaltet die Steuereinheit 4 über das Schaltelement 23 den Leistungsverstärker 22 während des Kalibriervorgangs aus.

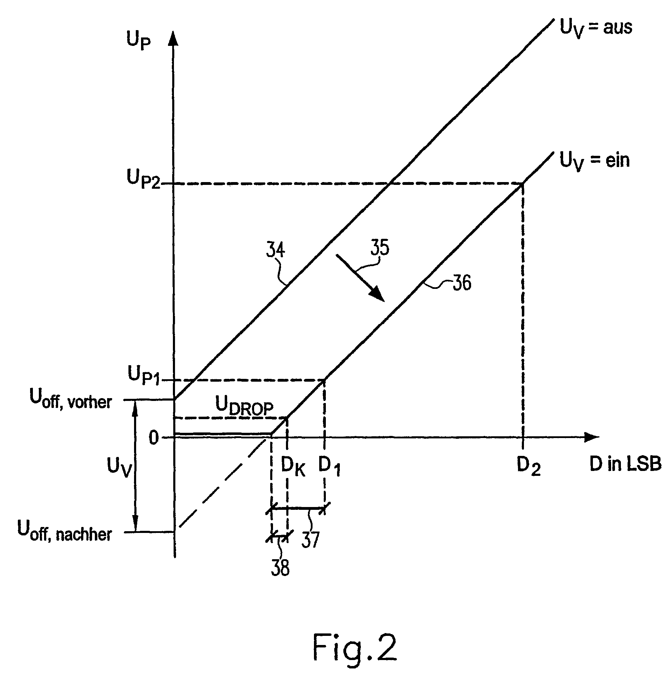

Die Berechnung des Offsetfehlers $U_{off}$ erfolgt in der Steuereinheit 4. Falls sich ein negativer Wert von $U_{off}$ ergibt, kann der Offsetfehler durch Addition eines positiven Offsetkorrekturwerts $D_K$ zum digitalen Leistungsvorgabesignal D beseitigt werden. Im Falle eines positiven Offsetfehlers müsste der Offsetkorrekturwert $D_K$ jedoch negative Werte annehmen. Um dies vermeiden zu können, wird in diesem Fall die anhand von Fig. 2 gezeigte Vorgehensweise gewählt.

In Fig. 2 ist das Leistungssteuersignal Up als Funktion des digitalen Leistungsvorgabesignals D aufgetragen. Das digitale Leistungsvorgabesignal wird in LSB (Least Significant Bits) angegeben. Bei ausgeschalteter Vorspannung $U_V$ wird der Zusammenhang zwischen D und Up durch die Kennlinie 34 dargestellt, deren Offsetfehler $U_{off,vorher}$ einen positiven Wert hat. In Fig. 2 ist auch die Drop-Out-Spannung $U_{DROP}$ eingetragen. Die betragsmäßig sehr kleine Spannung $U_{DROP}$ bezeichnet den Übergang vom gesättigten Bereich in den linearen Bereich. Beginnend mit der Spannung $U_{DROP}$ besteht ein linearer Zusammenhang zwischen dem digitalen Leistungsvorgabesignal D und dem analogen Leistungssteuersignal $U_P$.

Falls der Offsetfehler $U_{off}$ größer ist als die Drop-Out-Spannung $U_{DROP}$, dann wird die Vorspannung $U_V$ eingeschaltet und vom analogen Leistungsvorgabesignal 14 subtrahiert. Das Einschalten der Vorspannung wird über das Steuersignal 17 von der Steuereinheit 4 kontrolliert. Das Einschalten der Vorspannung $U_V$ verursacht eine durch den Pfeil 35 dargestellte Verschiebung der Kennlinie 34, so dass sich als neue Kennlinie die Kennlinie 36 ergibt. Zur Ermittlung des Offsetfehlers $U_{off,nachher}$ müssen erneut zu mindestens zwei digitalen Leistungsvorgabewerten $D_1$ und $D_2$ die zugehörigen analogen Leistungssteuersignale $U_{P1}$ sowie $U_{P2}$ gemessen werden. Aus diesen beiden Punkten kann dann von der Steuereinheit 4 der zur Kennlinie 36 gehörige neue Offsetfehler $U_{off,nachher}$ berechnet werden, der sich von dem zur Kennlinie 34 gehörigen Offsetfehler $U_{off,vorher}$ um die Vorspannung $U_V$ unterscheidet. Die verwendete Vorspannung $U_V$ sollte mindestens so groß sein wie die maximal zu erwartende positive Offsetspannung $U_{off,vorher}$ abzüglich der Drop-Out-Spannung $U_{DROP}$. Dadurch wird sichergestellt, dass sich nach der Verschiebung 35 auch wirklich ein negativer Wert des neuen Offsetfehlers $U_{off,nachher}$ ergibt. Der Vorteil davon ist, dass dieser mit Hilfe der Vorspannung $U_V$ erhaltene neue Offsetfehler $U_{off,nachher}$ wieder mittels eines positiven Offsetkorrekturwerts $D_K$ beseitigt werden kann. Ein nur positive Werte umfassender Wertebereich des Offsetkorrekturwerts $D_K$ und somit auch der Eingangswertebereich des Digital/Analog-Wandlers ist daher zur Kompensation sämtlicher auftretender Offsetfehler ausreichend, wenn im Fall von $U_{off} > U_{DROP}$ die Vorspannung $U_V$ eingeschaltet wird.

Aus Fig. 2 geht hervor, dass es sich bei dem Offsetkorrekturwert $D_K$ um den digitalen Leistungsvorgabewert handelt, der ein Leistungssteuersignal in Höhe von $U_{DROP}$ am Ausgang des Leistungssteuerpfads hervorruft. Die Drop-Out-Spannung $U_{DROP}$ bezeichnet den Beginn des Bereichs, in dem eine lineare Abhängigkeit zwischen dem digitalen Leistungsvorgabesignal D und dem Leistungssteuersignal $U_P$ besteht.

Der digitale Offsetkorrekturwert $D_K$ kann entsprechend der folgenden Gleichung von der Steuereinheit 4 be-rechnet werden:

$$D_K = D_1 - \frac{D_2 - D_1}{U_{P2} - U_{P1}} \cdot U_{P1} + \frac{U_{DROP}}{g_{DAC} \cdot g_{AMP}} \tag{6}$$

Das Zustandekommen dieser Formel kann man sich auf einfache Weise anhand von Fig. 2 veranschaulichen. Der Term

$$\frac{D_2 - D_1}{U_{P2} - U_{P1}} \cdot U_{P1} \tag{7}$$

entspricht dem Abstand 37, der von $D_1$ subtrahiert werden muss. Der Term

$$\frac{U_{DROP}}{g_{DAC} \cdot g_{AMP}} \qquad (8)$$

entspricht dem Abstand 38 und muss zu den bisher bestimmten Werten addiert werden, um zu dem digitalen Offsetkorrekturwert $D_K$ zu gelangen. Hierbei bezeichnet $g_{DAC}$ die Verstärkung des Digital-/Analog-Wandlers 13, während $g_{AMP}$ die Verstärkung des Operationsverstärkers 19 bezeichnet.

Der so ermittelte Offsetkorrekturwert $D_K$ wird von der Steuereinheit 4 an den digitalen Addierer 8 übermittelt, der diesen Offsetkorrekturwert $D_K$ dann zu dem jeweiligen digitalen Leistungsvorgabesignal D addiert. Wird nun vom Leistungsrampen-Generator 6 eine Leistungsrampe ausgegeben, welche mit dem digitalen Leistungsvorgabesignal D = 0 beginnt, so ist gewährleistet, dass die Rampe des Leistungssteuersignals Up mit der kleinsten noch im linearen Arbeitsbereich liegenden Spannung Up = $U_{DROP}$ beginnt. Die Drop-Out-Spannung $U_{DROP}$ muss dabei stets kleiner als die Schwellspannung des Leistungsverstärkers 22 sein, damit vor Beginn bzw. bei Beginn der Leistungsrampe auch dann keine Leistung abgestrahlt wird, wenn der Leistungsverstärker 22 bereits eingeschaltet ist.

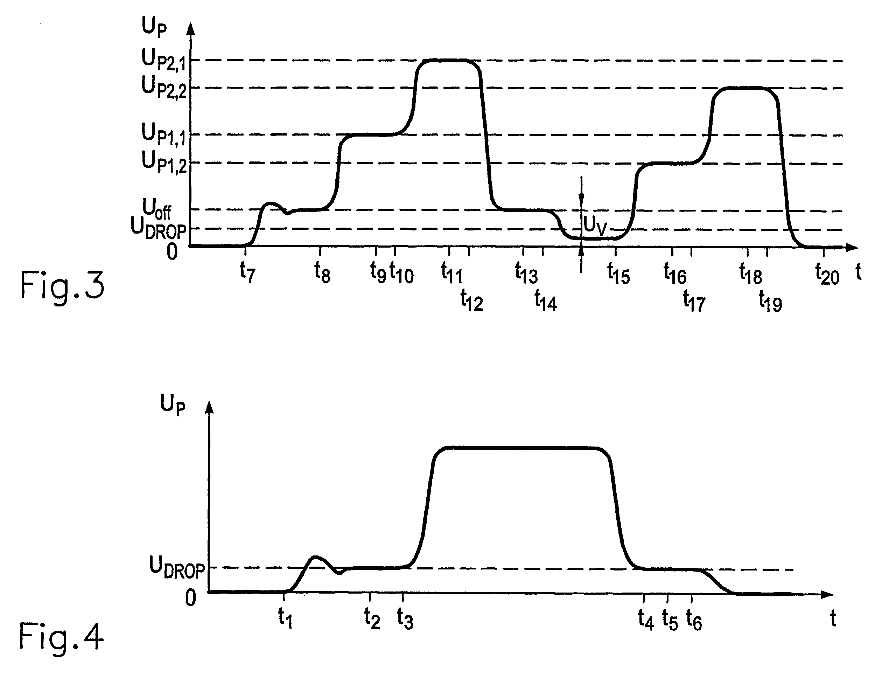

Der zeitliche Verlauf des Leistungssteuersignals $U_P$ während der Kalibrierphase ist beispielhaft in Fig. 3 dargestellt. Der Leistungsverstärker 22 bleibt während des gesamten Kalibrierverlaufs ausgeschaltet. Zu Beginn des Kalibriervorgangs ist der Offsetkorrekturwert $D_K$ auf Null gesetzt, so dass das digitale Leistungsvorgabesignal D durch den digitalen Addierer 8 nicht modifiziert wird. Die Vorspannung $U_V$ ist zu Beginn des Kalibriervorgangs ausgeschaltet.

Zum Zeitpunkt $t_7$ werden sowohl der Digital-/Analog-Wandler 13 als auch der Verstärker 19 eingeschaltet; am Digital-/AnalogWandler 13 liegt dabei der Digitalwert 0 an. Nach einer Einschwingphase stellt sich daher als Leistungssteuersignal $U_P$ die Offsetspannung $U_{off}$ ein. Zum Zeitpunkt $t_8$ gibt der Leistungsrampen-Generator 6 den Wert $D_1$ aus, so dass sich der Wert des Leistungssteuersignals zu $U_{P1}$ einstellt. Zur Ermittlung von $U_{P1}$ löst die Steuereinheit 4 zum Zeitpunkt $t_9$ entsprechende Messungen aus, welche durch die Messeinrichtung 20 durchgeführt werden. Zum Zeitpunkt $t_{10}$ beginnt der Leistungsrampen-Generator 6 den digitalen Leistungsvorgabewert $D_2$ auszugeben, so dass am Ausgang des Leistungssteuerpfads das Analogsignal $U_{P2}$ anliegt. Der Wert von $U_{P2}$ wird zum Zeitpunkt $t_{11}$ durch entsprechende Messungen der Messeinrichtung 20 ermittelt, welche durch das Steuergerät 4 ausgelöst werden. Zum Zeitpunkt $t_{12}$ wird an den Eingang des Digital-/Analog-Wandlers 13 wieder der Digitalwert 0 angelegt. Anschließend, zum Zeitpunkt $t_{13}$, ermittelt die Steuereinheit 4 den Offsetfehler $U_{off}$. Der Offsetfehler $U_{off}$ wird zum Zeitpunkt $t_{14}$ mit der Drop-Out-Spannung $U_{DROP}$ verglichen. Falls $U_{off} > U_{DROP}$ gilt, wird die Vorspannung $U_V$ über das Steuersignal 17 eingeschaltet. Anschließend werden die Messungen mit eingeschalteter Vorspannung $U_V$ wiederholt. Hierzu wird vom Leistungsrampen-Generator 6 zum Zeitpunkt $t_{15}$ der Wert $D_1$ erzeugt, so dass sich ein neues $U_{P1}$ ergibt, welches in Fig. 3 mit $U_{P1,2}$ bezeichnet ist. Zum Zeitpunkt $t_{16}$ löst die Steuereinheit 4 Messungen aus und ermittelt den Wert von $U_{P1,2}$. Ab dem Zeitpunkt $t_{17}$ gibt der Leistungsrampen-Generator den Wert $D_2$ aus, so dass ein neues $U_{P2,2}$ resultiert. Zum Zeitpunkt $t_{18}$ löst die Steuereinheit 4 Messungen zur Ermittlung des Werts von $U_{P2,2}$ aus. Anschließend können zum Zeitpunkt $t_{19}$ sowohl der Digital-/Analog-Wandler 13 als auch der Verstärker 19 ausgeschaltet werden. Zum Zeitpunkt $t_{20}$ berechnet die Steuereinheit 4 den Offsetkorrekturwert $D_K$ und führt diesen Wert dem digitalen Addierer 8 zu.

Nach erfolgter Kalibrierung steht der Offsetkorrekturwert $D_K$ fest und kann zur Korrektur des Offsetfehlers des Leistungssteuersignals während der Übertragung eines Datenbursts verwendet werden. In Fig. 4 ist der zeitliche Verlauf des Leistungssteuersignals $U_P$ während der Übertragung eines Datenbursts dargestellt. Zu Beginn der Übertragung des Datenbursts, zum Zeitpunkt $t_1$, werden sowohl der Digital-/AnalogWandler 13 als auch der Verstärker 19 eingeschaltet. Zu Beginn gibt der Leistungsrampen-Generator als digitales Leistungsvorgabesignal D den Wert 0 vor, zu dem im digitalen Addierer 8 der Offsetkorrekturwert $D_K$ addiert wird. In den Leistungssteuerpfad wird daher der Digitalwert $D_K$ eingespeist, und am Ausgang des Leistungssteuerpfads kann dann nach einer Einschwingphase das zugehörige Leistungssteuersignal Up = $U_{DROP}$, also die kleinste noch im linearen Arbeitsbereich liegende Spannung, abgegriffen werden. Zum Zeitpunkt $t_2$ wird der Leistungsverstärker 22 über das Schaltelement 23 aktiviert. Da die Drop-Out-Spannung $U_{DROP}$ kleiner als die Schwellspannung des Leistungsverstärkers gewählt wurde, wird noch keine Leistung abgestrahlt. Erst ab dem Zeitpunkt $t_3$ beginnt der Leistungsrampen-Generator 6 mit der Ausgabe der Einschaltrampe, mit der die Sendeleistung hochgefahren wird.

Wenn die gewünschte Sendeleistung erreicht ist, beginnt die Übertragung der Nutzdaten des Datenbursts. Anschließend erzeugt der Leistungsrampen-Generator 6 eine Ausschaltrampe, mit der die Sendeleistung wieder auf Null zurückgefahren wird. Das Ende der Ausschaltrampe ist zum Zeitpunkt $t_4$ erreicht. Die Synchronisation der Nutzdatenübertragung mit dem Beginn und Ende der Leistungsrampen erfolgt dabei mit Hilfe der Synchronisationsinformation 10. Nach dem Ende der Übertragung kann der Leistungsverstärker 22 mittels des Schaltelements 23 wieder ausgeschaltet werden. Dies geschieht zum Zeitpunkt $t_5$. Zum Zeitpunkt $t_6$ werden dann der Digital/Analog-Wandler 13 sowie der Verstärker 19 ausgeschaltet.

**Patentansprüche**

1. Vorrichtung zur Korrektur des Offsetfehlers ($U_{off}$) eines offsetfehlerbehafteten analogen Leistungssteuersignals ($U_P$), mit dem die Verstärkung des Leistungsverstärkers (22) eines Funkgeräts, und insbesondere eines Mobilfunkgeräts, vorgegeben wird, mit

   - einem Leistungsrampen-Generator (6), mit dem zum einen Leistungsrampen zum Herauf- und Herunterfahren der Sendeleistung als Folge von Digitalwerten (D) und zum anderen Kalibrierwerte ($D_1$, $D_2$) zur Ermittlung des Offsetfehlers ($U_{off}$) als digitale Kalibrierwerte erzeugbar sind,
   - einer Messeinrichtung (20), welche zu verschiedenen Kalibrierwerten ($D_1$, $D_2$) das zugehörige Leistungssteuersignal ($U_{P1}$, $U_{P2}$) misst,
   - einer Steuereinheit (4), welche aus den verschiedenen Kalibrierwerten ($D_1$, $D_2$) und den zugehörigen Messwerten des Leistungssteuersignals ($U_{P1}$, $U_{P2}$) den Offsetfehler ($U_{off}$) des Leistungssteuersignals ermittelt,
   - Mitteln zur Korrektur der vom Leistungsrampen-Generator (6) erzeugbaren Leistungsrampen um den ermittelten Offsetfehler, sowie
   - einem Leistungssteuerpfad, welcher die vom Leistungsrampen-Generator (6) erzeugten Digitalwerte (D) in das analoge Leistungssteuersignal (Up) umsetzt und einen Digital/Analog-Wandler (13) umfasst,

   **dadurch gekennzeichnet,**
   **dass** der Leistungssteuerpfad ferner einen analogen Subtrahierer (15) umfasst, mit dem das Signal, welches mit dem Ausgang (14) des Digital-/Analog-Wandlers (13) elektrisch verbunden ist, um eine vorgegebene Vorspannung ($U_V$) vermindert werden kann.

2. Vorrichtung nach Anspruch 1,
   **dadurch gekennzeichnet,**
   **dass** der Leistungsverstärker (22) eine analoge Regelung umfasst, welche die Verstärkung des Leistungsverstärkers (22) dem durch das Leistungssteuersignal ($U_P$) vorgegebenen Sollwert nachführt.

3. Vorrichtung nach einem der vorhergehenden Ansprüche,
   **dadurch gekennzeichnet,**
   **dass** zur Ermittlung des Offsetfehlers ($U_{off}$) mindestens zwei verschiedene Kalibrierwerte ($D_1$, $D_2$) sowie die zugehörigen Messwerte des Leistungssteuersignals ($U_{P1}$, $U_{P2}$) herangezogen werden.

4. Vorrichtung nach Anspruch 3,
   **dadurch gekennzeichnet,**
   **dass** die Steuereinheit (4) den Offsetfehler ($U_{off}$) durch eine lineare Näherung des Zusammenhangs zwischen den Kalibrierwerten ($D_1$, $D_2$) und den zugehörigen Messwerten des Leistungssteuersignals ($U_{P1}$, $U_{P2}$) bestimmt.

5. Vorrichtung nach einem der vorhergehenden Ansprüche,
   **dadurch gekennzeichnet,**
   **dass** der Leistungssteuerpfad einen dem Digital-/AnalogWandler (13) nachgeschalteten analogen Verstärker (19) umfasst.

6. Vorrichtung nach einem der vorhergehenden Ansprüche,
   **dadurch gekennzeichnet,**
   **dass** mittels der Steuereinheit (4) festgelegt werden kann, ob die Vorspannung ($U_V$) subtrahiert wird oder nicht.

7. Vorrichtung nach einem der vorhergehenden Ansprüche,
   **dadurch gekennzeichnet,**
   **dass** die Mittel zur Korrektur des Offsetfehlers einen Addierer (8) umfassen, der einen Offsetfehler-Korrekturwert ($D_K$) zu den vom Leistungsrampen-Generator (6) erzeugten Leistungsrampenwerten addiert.

8. Vorrichtung nach einem der Ansprüche 1 bis 6,
   **dadurch gekennzeichnet,**
   **dass** die Mittel zur Korrektur des Offsetfehlers die abgespeicherte Folge von Leistungsrampenwerten so modifizieren, dass der ermittelte Offsetfehler ($U_{off}$) kompensiert ist.

9. Vorrichtung nach einem der vorhergehenden Ansprüche,

**dadurch gekennzeichnet,**
**dass** in der Messeinrichtung (20) die Potentialdifferenz zwischen dem Leistungssteuersignal ($U_P$) und einem festen Referenzpotential (REF), insbesondere dem Massepotential, ermittelt wird.

**10.** Vorrichtung nach Anspruch 9,
**dadurch gekennzeichnet,**
**dass** die Messeinrichtung (20) einen steuerbaren Kreuzschalter (30) umfasst, wobei mittels des steuerbaren Kreuzschalters (30) eine Vorzeichenumkehr der zu verstärkenden Potentialdifferenz bewirkt werden kann.

**11.** Vorrichtung nach Anspruch 9 oder Anspruch 10,
**dadurch gekennzeichnet,**
**dass** die Messeinrichtung (20) einen Differenzverstärker (31) zur Verstärkung der Potentialdifferenz umfasst.

**12.** Vorrichtung nach einem der Ansprüche 9 bis 11,
**dadurch gekennzeichnet,**
**dass** die Messeinrichtung (20) einen Analog-/Digital-Wandler (33) zur Digitalisierung der Potentialdifferenz umfasst.

**13.** Vorrichtung nach einem der vorhergehenden Ansprüche,
**dadurch gekennzeichnet,**
**dass** die Vorrichtung ein Schaltelement (23) für den Leistungsverstärker (22) umfasst, mit dem der Leistungsverstärker (22) während des Kalibriervorgangs ausschaltbar ist.

**14.** Vorrichtung nach einem der vorhergehenden Ansprüche,
**dadurch gekennzeichnet,**
**dass** der Leistungsrampen-Generator (6), die Messeinrichtung (20) und die Steuereinheit (4) oder eine entsprechende Teilkombination dieser Komponenten auf dem Basisbandbaustein bzw. den Basisbandbausteinen (3) angeordnet sind.

**15.** Vorrichtung nach Anspruch 14,
**dadurch gekennzeichnet,**
**dass** das vom Leistungssteuerpfad gelieferte Leistungssteuersignal ($U_P$) der Messeinrichtung (20) innerhalb des Basisbandbausteins (3) direkt zugeführt wird.

**16.** Mobilfunkstation, welche eine Vorrichtung entsprechend einem der Ansprüche 1 bis 15 aufweist.

**17.** Mobilfunkstation nach Anspruch 16,
**dadurch gekennzeichnet,**
**dass** die Datenübertragung entsprechend einem der Standards GSM, EDGE, TIA-/EIA-136, UMTS oder entsprechend von Teilkombinationen dieser Standards erfolgt.

**18.** Verfahren zur Korrektur des Offsetfehlers ($U_{off}$) eines offsetfehlerbehafteten analogen Leistungssteuersignals ($U_P$), mit dem die Verstärkung des Leistungsverstärkers (22) eines Funkgeräts, und insbesondere eines Mobilfunkgeräts, vorgegeben wird, mit folgenden Schritten:

a) Erzeugen von verschiedenen Kalibrierwerten als digitale Kalibrierwerte ($D_1$, $D_2$) zur Ermittlung des Offsetfehlers ($U_{off}$) mittels des Leistungsrampen-Generators (6), mit dem auch die Leistungsrampen als Folge von Digitalwerten zum Herauf- und Herunterfahren der Sendeleistung erzeugbar sind;
b) Messen der zu den verschiedenen Kalibrierwerten ($D_1$, $D_2$) gehörigen und aus diesen durch Digital-/Analog-Wandlung (13) erzeugten Werte des Leistungssteuersignals ($U_{P1}$, $U_{P2}$);
c) Ermitteln des Offsetfehlers ($U_{off}$) aus den verschiedenen Kalibrierwerten ($D_1$, $D_2$) sowie den zugehörigen Messwerten des Leistungssteuersignals ($U_{P1}$, $U_{P2}$);
d) Korrigieren der vom Leistungsrampen-Generator (6) erzeugbaren Leistungsrampen um den in Schritt c) ermittelten Offsetfehler,

**dadurch gekennzeichnet,**
**dass** das Korrigieren in Schritt d) mittels eines analogen Subtrahierers (15) durchgeführt wird, mit dem ein Signal im Signalweg hinter der Digital-/Analog-Wandlung (13) um eine vorgegebene Vorspannung ($U_V$) reduziert werden kann.

**19.** Verfahren nach Anspruch 18,
**dadurch gekennzeichnet,**
**dass** die Verstärkung des Leistungsverstärkers (22) mittels einer analogen Regelung dem durch das Leistungssteuersignal ($U_p$) vorgegebenen Sollwert nachgeführt wird.

**20.** Verfahren nach Anspruch 18 oder Anspruch 19,
**dadurch gekennzeichnet,**
**dass** zum Ermitteln des Offsetfehlers ($U_{off}$) mindestens zwei verschiedene Kalibrierwerte ($D_1$, $D_2$) sowie die zugehörigen Messwerte des Leistungssteuersignals ($U_{P1}$, $U_{P2}$) herangezogen werden.

**21.** Verfahren nach einem der Ansprüche 18 bis 20,
**dadurch gekennzeichnet,**
**dass** der Offsetfehler ($U_{off}$) durch eine lineare Näherung des Zusammenhangs zwischen den Kalibrierwerten ($D_1$, $D_2$) und den zugehörigen Messwerten des Leistungssteuersignals ($U_{P1}$, $U_{P2}$) ermittelt wird.

**22.** Verfahren nach einem der Ansprüche 18 bis 21,
**dadurch gekennzeichnet,**
**dass** die vom Leistungsrampen-Generator (6) erzeugbaren Leistungsrampen um den in Schritt c) ermittelten Offsetfehler korrigiert werden, indem ein Offsetfehler-Korrekturwert ($D_K$) zu den vom Leistungsrampen-Generator (6) erzeugten Leistungsrampenwerten addiert wird.

**23.** Verfahren nach einem der Ansprüche 18 bis 21,
**dadurch gekennzeichnet,**
**dass** die vom Leistungsrampen-Generator (6) erzeugbaren Leistungsrampen um den in Schritt c) ermittelten Offsetfehler korrigiert werden, indem die abgespeicherte Folge von Leistungsrampenwerten so modifiziert wird, dass der ermittelte Offsetfehler kompensiert ist.

**24.** Verfahren nach einem der Ansprüche 18 bis 23,
**dadurch gekennzeichnet,**
**dass** der Leistungsverstärker (22) während des Kalibriervorgangs ausgeschaltet wird.

**Claims**

**1.** Device for correcting the offset error ($U_{off}$) of an analogue power control signal ($U_P$) with an offset error, by means of which the gain of the power amplifier (22) of a transceiver and, in particular, a mobile transceiver, is preset, comprising

- a power ramp generator (6) by means of which, on the one hand, power ramps can be generated for ramping the transmit power up and down as a sequence of digital values (D) and, on the other hand, calibration values ($D_1$, $D_2$) can be generated for determining the offset error ($U_{off}$) as digital calibration values,
- a measuring device (20) which measures the associated power control signal ($U_{P1}$, $U_{P2}$) for various calibration values ($D_1$, $D_2$),
- a control unit (4) which determines the offset error ($U_{off}$) of the power control signal from the various calibration values ($D_1$, $D_2$) and the associated measurement values of the power control signal ($U_{P1}$, $U_{P2}$), and
- means for correcting the power ramps, which can be generated by the power ramp generator (6), by the offset error determined, and
- a power control path which converts the digital values (D) generated by the power ramp generator (6) has to the analogue power control signal ($U_P$) and a digital/analogue converter (13),

**characterized in that** the power control path also has an analogue subtractor (15) by means of which the signal which is electrically connected to the output (14) of the digital/analogue converter (13) can be reduced by a predetermined bias voltage ($U_V$).

**2.** Device according to Claim 1, **characterized in that** the power amplifier (22) has an analogue control system which corrects the gain of the power amplifier (22) to the set point value predetermined by the power control signal ($U_P$).

3. Device according to one of the preceding claims, **characterized in that** at least two different calibration values ($D_1$, $D_2$) and the associated measurement values of the power control signal ($U_{P1}$, $U_{P2}$) are used for determining the offset error ($U_{off}$).

4. Device according to Claim 3, **characterized in that** the control unit (4) determines the offset error ($U_{off}$) by means of a linear approximation of the relationship between the calibration values ($D_1$, $D_2$) and the associated measurement values of the power control signal ($U_{P1}$, $U_{P2}$).

5. Device according to one of the preceding claims, **characterized in that** the power control path has an analogue amplifier (19) following the digital/analogue converter (13).

6. Device according to one of the preceding claims, **characterized in that** the control unit (4) can determine whether or not the bias voltage ($U_V$) is subtracted.

7. Device according to one of the preceding claims, **characterized in that** the means for correcting the offset error have an adder (8) which adds an offset error correction value ($D_K$) to the power ramp values generated by the power ramp generator (6).

8. Device according to one of Claims 1 to 6, **characterized in that** the means for correcting the offset error modify the stored sequence of power ramp values in such a manner that the offset error ($U_{off}$) determined is compensated for.

9. Device according to one of the preceding claims, **characterized in that** the potential difference between the power control signal ($U_P$) and a fixed reference potential (REF), particularly the earth potential, is determined in the measuring device (20).

10. Device according to Claim 9, **characterized in that** the measuring device (20) has a controllable intermediate switch (30), by means of which the sign of the potential difference to be amplified can be reversal.

11. Device according to Claim 9 or Claim 10, **characterized in that** the measuring device (20) has a differential amplifier (31) for amplifying the potential difference.

12. Device as claimed in one of Claims 9 to 11, **characterized in that** the measuring device (20) has an analogue/digital converter (33) for digitizing the potential difference.

13. Device as claimed in one of the preceding claims, **characterized in that** the device has a switching element (23) for the power amplifier (22) by means of which the power amplifier (22) can be switched off during the calibration process.

14. The device as claimed in one of the preceding claims, **characterized in that** the power ramp generator (6), the measuring device (20) and the control unit (4), or a corresponding partial combination of these components, are/is arranged on the baseband chip or the baseband chips (3), respectively.

15. Device according to Claim 14, **characterized in that** the power control signal ($U_P$) produced by the power control path is directly supplied to the measuring device (20) inside the baseband chip (3).

16. Mobile station which has a device according to one of Claims 1 to 15.

17. Mobile station as claimed in Claim 16, **characterized in that** the data is transmitted in accordance with one of the GSM, EDGE, TIA/EIA-136, UMTS standards or in accordance with partial combinations of these standards.

18. Method for correcting the offset error ($U_{off}$) of an analogue power control signal ($U_P$) with an offset or error, by means of which the gain of the power amplifier (22) of a transceiver and, in particular, a mobile transceiver, is preset, having the following steps:

a) generating various calibration values as digital calibration values ($D_1$, $D_2$) for determining the offset error ($U_{off}$) by means of the power ramp generator (6), by means of which the power ramps can also be generated as a sequence of digital values for ramping the transmit power up and down;

b) measuring the values of the power control signal ($U_{P1}$, $U_{P2}$) associated with the various calibration values ($D_1$, $D_2$) which can be generated from these by a digital/analogue conversion (13);

c) determining the offset error ($U_{off}$) from the various calibration values ($D_1$, $D_2$) and the associated measurement values of the power control signal ($U_{P1}$, $U_{P2}$);

d) correcting the power ramps, which can be generated by the power ramp generator (6), by the offset error determined in step c),

**characterized in that** the correction process in step d) is carried out by means of an analogue subtractor (15) by means of which a signal in the signal path downstream from the digital/analogue conversion (13) can be reduced by a predetermined bias voltage ($U_V$).

**19.** Method according to Claim 18, **characterized in that** the gain of the power amplifier (22) is corrected to the set point value predetermined by the power control signal ($U_P$) by means of an analogue control system.

**20.** Method according to Claim 18 or Claim 19, **characterized in that** at least two different calibration values ($D_1$, $D_2$) and the associated measurement values of the power control signal ($U_{P1}$, $U_{P2}$) are used for determining the offset error ($U_{off}$).

**21.** Method according to one of Claims 18 to 20, **characterized in that** the offset error ($U_{off}$) is determined by linear approximation of the relationship between the calibration values ($D_1$, $D_2$) and the associated measurement values of the power control signal ($U_{P1}$, $U_{P2}$).

**22.** Method according to one of Claims 18 to 21, **characterized in that** the power ramps, which can be generated by the power ramp generator (6), are corrected by the offset error determined in step c) by adding an offset error correction value ($D_K$) to the power ramp values generated by the power ramp generator (6).

**23.** Method as claimed in one of Claims 18 to 21, **characterized in that** the power ramps, which can be generated by the power ramp generator (6), are corrected by the offset error determined in step c) by modifying the stored sequence of power ramp values in such a manner that the offset error determined is compensated for.

**24.** Method according to one of Claims 18 to 23, **characterized in that** the power amplifier (22) is switched off during the calibration process.

**Revendications**

**1.** Dispositif de correction de l'erreur ($U_{off}$) de décalage d'un signal ($U_P$) analogique de commande de puissance ayant une erreur de décalage, par lequel le gain de l'amplificateur (22) de puissance d'un appareil radio, et notamment d'un appareil téléphonique mobile, est prescrit, comprenant

- un générateur (6) de rampes de puissance, par lequel, d'une part, peuvent être produites des rampes de puissance pour augmenter et abaisser la puissance d'émission sous la forme de valeurs (D) numériques et, d'autre part, des valeurs ($D_1$, $D_2$) d'étalonnage pour la détermination de l'erreur ($U_{off}$) de décalage sous la forme de valeurs numériques d'étalonnage,
- un dispositif (20) de mesure qui mesure, pour diverses valeurs ($D_1$, $D_2$) d'étalonnage, le signal ($U_{p1}$, $U_{p2}$) associé de commande de puissance,
- une unité (4) de commande qui détermine, à partir des diverses valeurs ($D_1$, $D_2$) d'étalonnage et des valeurs de mesure associées du signal ($U_{p1}$, $U_{p2}$) de commande de puissance, l'erreur ($U_{off}$) de décalage du signal de commande de puissance,
- des moyens de correction des rampes de puissance, qui peuvent être obtenus par le générateur (6) de rampes de puissance, de l'erreur de décalage déterminée, ainsi que
- un trajet de commande de puissance qui transforme les valeurs (D) numériques produites par le générateur (6) de rampes de puissance en le signal ($U_P$) analogique de commande de puissance et qui comprend un convertisseur (13) numérique/analogique,

**caractérisé**
**en ce que** le trajet de commande de puissance comprend, en outre, un soustracteur (15) analogique, par lequel le signal qui est relié électriquement à la sortie (14) du convertisseur (13) numérique/analogique peut être diminué d'une tension ($U_V$) de polarisation donnée à l'avance.

2. Dispositif suivant la revendication 1, **caractérisé**
**en ce que** l'amplificateur (22) de puissance comprend une régulation analogique qui règle le gain de l'amplificateur (22) de puissance suivant la valeur de consigne prescrite par le signal ($U_P$) de commande de puissance.

3. Dispositif suivant l'une des revendications précédentes, **caractérisé**
**en ce qu'**il est tiré parti, pour la détermination de l'erreur ($U_{off}$) de décalage, d'au moins deux valeurs ($D_1$, $D_2$) différentes d'étalonnage, ainsi que des valeurs de mesure associées du signal ($U_{p1}$, $U_{p2}$) de commande de puissance.

4. Dispositif suivant la revendication 3, **caractérisé**
**en ce que** l'unité (4) de puissance détermine l'erreur ($U_{off}$) de décalage par une approximation linéaire de la relation entre les valeurs ($D_1$, $D_2$) d'étalonnage et les valeurs de mesure associées du signal ($U_{p1}$, $U_{p2}$) de commande de puissance.

5. Dispositif suivant l'une des revendications précédentes, **caractérisé**
**en ce que** le trajet de commande de puissance comprend un amplificateur (19) analogique monté en aval du convertisseur (13) numérique/analogique.

6. Dispositif suivant l'une des revendications précédentes, **caractérisé**
**en ce qu'**il peut être constaté, au moyen de l'unité (4) de commande, si la tension ($U_v$) de polarisation est soustraite ou ne l'est pas.

7. Dispositif suivant l'une des revendications précédentes, **caractérisé**
**en ce que** les moyens de correction de l'erreur de décalage comprennent un additionneur (8) qui additionne une valeur ($D_K$) de correction d'erreur de décalage aux valeurs de rampes de puissance produites par le générateur (6) de rampes de puissance.

8. Dispositif suivant l'une des revendications 1 à 6, **caractérisé,**
**en ce que** les moyens de correction de l'erreur de décalage modifient la suite mémorisée de valeurs de rampes de puissance, de manière à compenser l'erreur ($U_{off}$) de décalage déterminée.

9. Dispositif suivant l'une des revendications précédentes, **caractérisé**
**en ce que**, dans le dispositif (20) de mesure, est déterminée la différence de potentiel entre le signal (Up) de commande de puissance et un potentiel (REF) de référence fixe, notamment le potentiel de masse.

10. Dispositif suivant la revendication 9, **caractérisé**
**en ce que** le dispositif (20) de mesure comprend un interrupteur inverseur (30) qui peut être commandé, une inversion de signes de la différence de potentiel à amplifier pouvant être provoquée par l'interrupteur inverseur (30) qui peut être commandé.

11. Dispositif suivant la revendication 9 ou la revendication 10, **caractérisé**
**en ce que** le dispositif (20) de mesure comprend un amplificateur (31) différentiel pour amplifier la différence de potentiel.

12. Dispositif suivant l'une des revendications 9 à 11, **caractérisé**
**en ce que** le dispositif (20) de mesure comprend un convertisseur (33) analogique/numérique pour numériser la différence de potentiel.

13. Dispositif suivant l'une des revendications précédentes, **caractérisé**
**en ce que** le dispositif comprend un élément (23) de commutation pour l'amplificateur (22) de puissance par lequel l'amplificateur (22) de puissance peut être mis hors circuit pendant l'opération d'étalonnage.

14. Dispositif suivant l'une des revendications précédentes, **caractérisé**
**en ce que** le générateur (6) de rampes de puissance, le dispositif (20) de mesure et l'unité (4) de commande ou une sous-combinaison correspondante de ces composants sont montés sur le module de bande de base ou sur les modules (3) de bande de base.

**15.** Dispositif suivant la revendication 14, **caractérisé**

**en ce que** le signal (Up) de commande de puissance fourni par le trajet de commande de puissance est envoyé directement au dispositif (20) de mesure au sein du module (3) de bande de base.

**16.** Station de téléphonie mobile qui a un dispositif suivant l'une des revendications 1 à 15.

**17.** Station de téléphonie mobile suivant la revendication 16, **caractérisée**

**en ce que** la transmission des données s'effectue suivant l'un des standards GSM, EDGE, TIA-/EIA-136, UMTS ou des sous-combinaisons de ces standards.

**18.** Procédé de correction de l'erreur ($U_{off}$) de décalage d'un signal ($U_P$) analogique de commande de puissance ayant une erreur de décalage, par lequel le gain de l'amplificateur (22) de puissance d'un appareil radio, et notamment d'un appareil téléphonique mobile, est prescrit, comprenant les stades suivants :

a) production de diverses valeurs d'étalonnage sous forme de valeurs ($D_1$, $D_2$) numériques d'étalonnage pour la détermination de l'erreur ($U_{off}$) de décalage au moyen du générateur (6) de rampes de puissance, par lequel les rampes de puissance peuvent être produites aussi sous la forme d'une suite de valeurs numériques pour diminuer et augmenter la puissance d'émission ;
b) mesure des valeurs du signal ($U_{p1}$, $U_{p2}$) de commande de puissance associées aux diverses valeurs ($D_1$, $D_2$) d'étalonnage et produites à partir de celles-ci par une conversion (13) numérique/analogique ;
c) détermination de l'erreur ($U_{off}$) de décalage à partir des diverses valeurs (D1, D2) d'étalonnage, ainsi que des valeurs de mesure associées du signal ($U_{p1}$, $U_{p2}$) de commande de puissance ;
d) correction des rampes de puissance, pouvant être produites par le générateur (6) de rampes de puissance, de l'erreur de décalage déterminée au stade c),

**caractérisé**

**en ce que** l'on effectue la correction au stade d) au moyen d'un soustracteur (15) analogique par lequel un signal dans le trajet du signal en aval de la conversion (13) numérique/analogique peut être réduit d'une tension ($U_v$) de polarisation prescrite.

**19.** Procédé suivant la revendication 18, **caractérisé**

**en ce que** l'on règle le gain de l'amplificateur (22) de puissance au moyen d'une régulation analogique suivant la valeur de consigne prescrite par le signal (Up) de commande de puissance.

**20.** Procédé suivant la revendication 18 ou la revendication 19, **caractérisé**

**en ce que** l'on tire parti, pour la détermination de l'erreur ($U_{off}$) de décalage, d'au moins deux valeurs ($D_1$, $D_2$) différentes d'étalonnage, ainsi que des valeurs de mesure associées du signal ($U_{p1}$, $U_{p2}$) de commande de puissance.

**21.** Procédé suivant l'une des revendications 18 à 20, **caractérisé**

**en ce que** l'on détermine l'erreur ($U_{off}$) de décalage par une approximation linéaire de la relation entre les valeurs ($D_1$, $D_2$) d'étalonnage et les valeurs de mesure associées du signal ($U_{P1}$, $U_{P2}$) de commande de puissance.

**22.** Procédé suivant l'une des revendications 18 à 21, **caractérisé**

**en ce que** l'on corrige les rampes de puissance, qui peuvent être produites par le générateur (6) de rampes de puissance, de l'erreur de décalage déterminée au stade c) en ajoutant une valeur ($D_K$) de correction d'erreur de décalage aux valeurs de rampes de puissance produites par le générateur (6) de rampes de puissance.

**23.** Procédé suivant l'une des revendications 18 à 21, **caractérisé**

**en ce que** l'on corrige les rampes de puissance, qui peuvent être reproduites par le générateur (6) de rampes de puissance, de l'erreur de décalage déterminée au stade c) en modifiant la suite mémorisée de valeurs de rampes de puissance, de façon à compenser l'erreur de décalage déterminée.

**24.** Procédé suivant l'une des revendications 18 à 23, **caractérisé**

**en ce que** l'on met hors circuit l'amplificateur (22) de puissance pendant l'opération d'étalonnage.

Fig.1

Fig.2

EP 1 413 064 B1

Fig.3

Fig.4